# EUROPEAN PATENT SPECIFICATION

(11) **EP 1 444 869 B1**
(45) Date of publication and mention of the grant of the patent: **13.04.2011**
(21) Application number: 02781992.9
(22) Date of filing: 30.10.2002
(51) Int. Cl.: H05B 33/18, H05B 33/14, H05B 33/20

(54) **ORGANIC LIGHT-EMITTING DEVICE HAVING HIGH LUMINESCENT EFFICIENCY**
ORGANISCHES LICHTEMISSIONSBAUELEMENT MIT HOHER LUMINESZENZEFFIZIENZ
DISPOSITIF ELECTROLUMINESCENT ORGANIQUE A LUMINESCENCE HAUTEMENT EFFICACE

(30) Priority: 12.11.2001 KR 2001070024
(43) Date of publication of application: 11.08.2004
(73) Proprietor: Neoviewkolon Co., Ltd., 464-871 Kyonggi-do (KR)
(72) Inventor: KIM, Hae-Won, 467-704 Kyonggi-Do (KR); IM,Woo-Bin,, Hongseong-Gun, Chungcheongnam-Do, 350-756, (KR)
(74) Representative: Merkle, Gebhard
(86) International application number: PCT/KR2002/002021
(87) International publication number: WO 2003/043383

(56) References cited:
- EP-A- 1 009 041
- EP-A- 1 109 234
- EP-A2- 1 009 041
- WO-A-00/16593
- JP-A- 8 138 868
- JP-A- 2000 235 893
- JP-A- 2001 167 886

## Description

### FIELD OF THE INTENTION

The present invention relates to an organic light-emitting device (OLED) having high luminescent efficiency and, more particularly, to an OLED having high luminescent efficiency and long lifetime in which most holes and electrons are combined in a light-emitting layer of the OLED.

### BACKGROUNDS OF THE INVENTION

Generally, an OLED has a transparent anode, a metal cathode and a light-emitting layer including a low molecular or polymeric luminescent organic compound and formed between the anode and the cathode. When a voltage is applied between the anode and the cathode, light is radiated from the light-emitting layer. The OLED has not only a fast response speed but also an excellent brightness and wide viewing angle. Also, the OLED has advantages that the OLED operates with a low driving voltage, and full colors in a visible region can be displayed, and it does not need a backlight for light-emitting due to its self-light emitting property. In addition, the OLED can be manufactured into a thin film and flexible type device, and can be mass-produced by well-known film fabrication techniques.

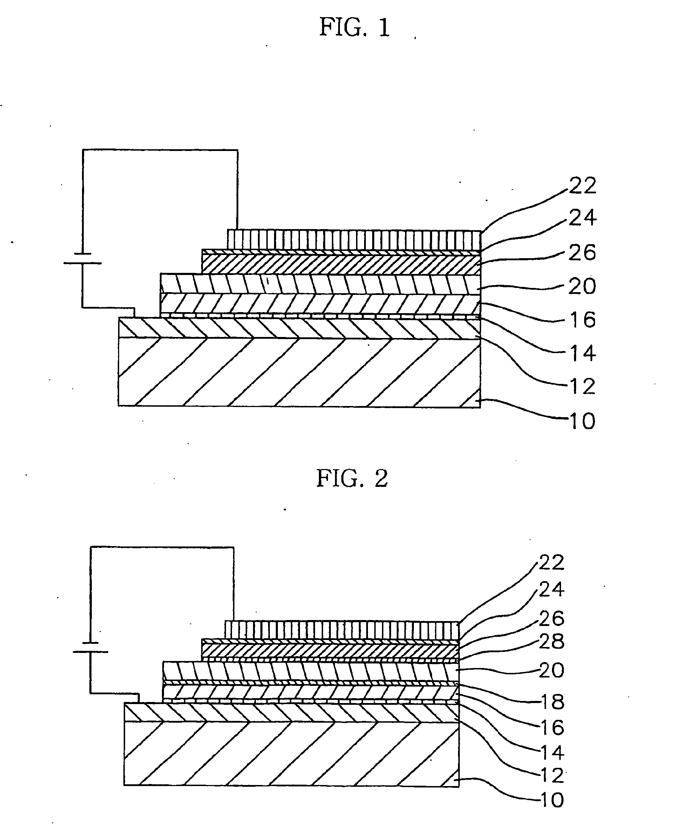

Fig. 1 shows a cross sectional view of a conventional OLED. As shown in Fig.1, the OLED includes the first electrode 12 (anode), at least one organic light-emitting layer 20 formed on the first electrode 12, and the second electrode 22 (cathode) formed on the light-emitting layer 20 while facing the first electrode 12. Conventionally, the first electrode 12 is made of materials having a high work function, for example, Indium Tin Oxide, polyaniline and Ag, and the second electrode 22 is made of materials having a low work function (generally, less than 4eV), for example, Al, Mg-Ag, Li, and Ca. The organic light-emitting layer 20 is composed of an organic luminescent single compound or a conjugated polymer. In addition, a hole injecting layer 14 and a hole transporting layer 16 are provided between the first electrode 12 and the light-emitting layer 20 to facilitate hole injection and transportation. The hole injecting layer 14 is made of materials having an ionization potential higher than that of the anode and lower than that of the light-emitting layer 20, and the hole transporting layer 16 is made of materials having an ionization potential higher than that of the hole injecting layer 14 and lower than that of the light-emitting layer 20. Also, an electron injecting layer 24 and an electron transporting layer 26 can be generally provided between the second electrode 22 and the light-emitting layer 20 to facilitate electron injection and transportation. The electron injecting layer 24 is made of materials having work function higher than that of the cathode 22 and an electron affinity lower than that of the electron transporting layer 26, and the electron transporting layer 26 is made of materials having an electron affinity higher than that of the electron injecting layer 24 and lower than that of the light-emitting layer 20.

In operation, the hole and the electron are produced at the anode 12 and the cathode 16 by applying a voltage. The produced hole and the electron are injected into the light-emitting layer 20 via the hole injecting layer 14, the hole transporting layer 16, the electron injecting layer 24 and the electron transporting layer 26. The injected holes and the electrons are recombined in the light-emitting layer 20, which induces light radiation, and the radiated light is displayed through the anode 12 and a substrate 10 made of optically transparent material.

Amount of holes and electrons injected to the light-emitting layer 20 can be adjusted by modifying the thickness of the hole injecting layer 14, the hole transporting layer 16, the electron injecting layer 24 or the electron transporting layer 26 or by modifying the materials composing the layers. However, it is generally difficult to precisely control the thickness of each layer in a large-size OLED. In addition, as the voltage applied between the anode 12 and the cathode 22 increases, the amount of the injected electrons increases. In this case, a part of the injected electrons passes through the light-emitting layer 20, and is extinguished in a layer other than the light-emitting layer 20. Thus, the part of the electron cannot used for light-emitting, which deteriorates the luminescent efficiency of the OLED.

To obtain a favorable colour emission with high efficiency European Patent Application (EP 1 109 234 A2), discloses an organic light emitting device with a multi-layer structure with an emission layer and an electron layer between an anode and a cathode, wherein an intermediate layer comprising a material, having an ionization potential larger than the material used for the emission layer, is provided between the emission layer and electron layer.

The International Patent application WO 00/16593 also discloses a light emitting device comprising a multi-layer structure including a transparent anode, a hole transporting layer over the anode, an emission layer over the hole transporting layer and a cathode in electrical contact with the electron transporting layer.

### SUMMARY OF THE INVENTION

It is an object of the present invention to provide an OLED having high luminescent efficiency in which most electrons and holes are combined within a light-emitting layer of the OLED.

It is another object of the present invention to improve the luminescent efficiency of an OLED, thereby to increase the life-time of the OLED.

To accomplish these objects, the present invention provides an OLED comprising a first electrode formed on a substrate, at least one organic layer including an organic light-emitting layer, a second electrode formed on the organic layer, a hole inducing layer including a material having an ionization potential higher than that of the organic light-emitting layer and formed between the first electrode and the organic light-emitting layer

The hole inducing layer is interposed between a hole transporting layer formed on the first electrode and the light-emitting layer. Preferably the electron blocking layer is interposed between an electron transporting layer formed on the light-emitting layer and the light-emitting layer. Alternatively, the hole inducing layer and the electron blocking layer may be formed by being mixed with the hole transporting layer and the electron transporting layer, respectively.

### BRIEF DESCRIPTION OF THE DRAWINGS

A more complete appreciation of the invention, and many of the attendant advantages thereof, will be readily apparent by reference to the following detailed description when considered in conjunction with the accompanying drawings in which like reference numerals indicate the same or the similar components, wherein:
Fig. 1 is a cross sectional view of a conventional OLED;
Fig. 2 is a cross sectional view of an OLED according to an embodiment of the present invention;
Figs. 3a and 3b are energy band diagrams of OLEDs according to a conventional art and an embodiment of the present invention, respectively;
Figs. 4a and 4b are graphs showing the relationship of an applied voltage vs. a current density and a brightness of OLEDs according to a conventional art and an embodiment of the present invention, respectively; and
Figs. 5a and 5b are graphs showing a relationship of an applied voltage vs. a luminescent efficiency of the OLEDs according to a conventional art and an embodiment of the present invention, respectively.

### DETAILED DESCRIPTION OF THE INVENTION

Fig. 2 is a cross sectional view of an OLED according to an embodiment of the present invention. As shown in Fig.2, the OLED according to the present invention radiates light by interposing a light emitting organic material between two electrodes, and applying an operation voltage between the electrodes. One of the two electrodes must be transparent for transmission of the radiated light.

As shown in Fig. 2, the OLED according to an embodiment of the present invention includes an anode 12, a hole injecting layer 14, a hole transporting layer 16, a hole inducing layer 18, a light-emitting layer 20, an electron blocking layer 28, an electron transporting layer 26, an electron injecting layer 24 and a cathode 22, which are successively formed on a substrate 10. The hole injecting layer 14 and the electron injecting layer 24 can be optionally formed in accordance with the structure of the OLED.

The hole inducing layer 18 may be formed by doping or depositing a material having an ionization potential higher than that of the light-emitting layer 20 on the hole transporting layer 16. Alternatively, the hole inducing layer 18 may be formed in the hole transporting layer 16 in a mixed form by mixing the material for producing the hole inducing layer 18 with the material for producing the hole transporting layer 16 and then depositing them. In this case, the hole inducing layer's practical thickness can be 0 to 500Å, preferably 1 to 100Å.

In order to control amount of electrons injected to the light-emitting layer 20, the electron blocking layer 28 may be formed by doping or depositing a material having an electron affinity higher than that of the light-emitting layer 20 on the light-emitting layer 20. Alternatively, the electron blocking layer 28 may be formed in the electron transporting layer 26 in a mixed form by mixing the material for producing the electron blocking layer 18 with the material for producing the electron transporting layer 26 and then depositing them. In this case, the electron blocking layer's practical thickness can be 0 to 500Å, preferably 1 to 100Å.

In the OLED according to the present invention, the hole inducing layer 18 is formed with a material having an ionization potential higher than that of the light-emitting layer 20, that is, with a material having a HOMO energy level lower than that of the light-emitting layer 20. Thus, the electrons in the light-emitting layer 20 can be inductively injected to the hole inducing layer 18. Thereby the hole density of the light-emitting layer 20 increases, and the luminescent efficiency of the OLED increases. The electron blocking layer 28 is formed with a material having an electron affinity higher than that of the light-emitting layer 20, that is, with a material having a LUMO energy level higher than that of the light-emitting layer 20. Thus, the amount of the electrons injected into the light-emitting layer 20 can be controlled by the electron blocking layer 28. Therefore, the amount of the electrons and amount of the holes injected to the light-emitting layer 20 can be balanced, and the possibility for recombination of the electrons and the holes in the light-emitting layer 20 increases, and the luminescent efficiency of the OLED increases. Though the OLED of Fig. 2 includes both the hole inducing layer 18 and the electron blocking layer 28, the OLED according to the present invention can include one of the two layers..

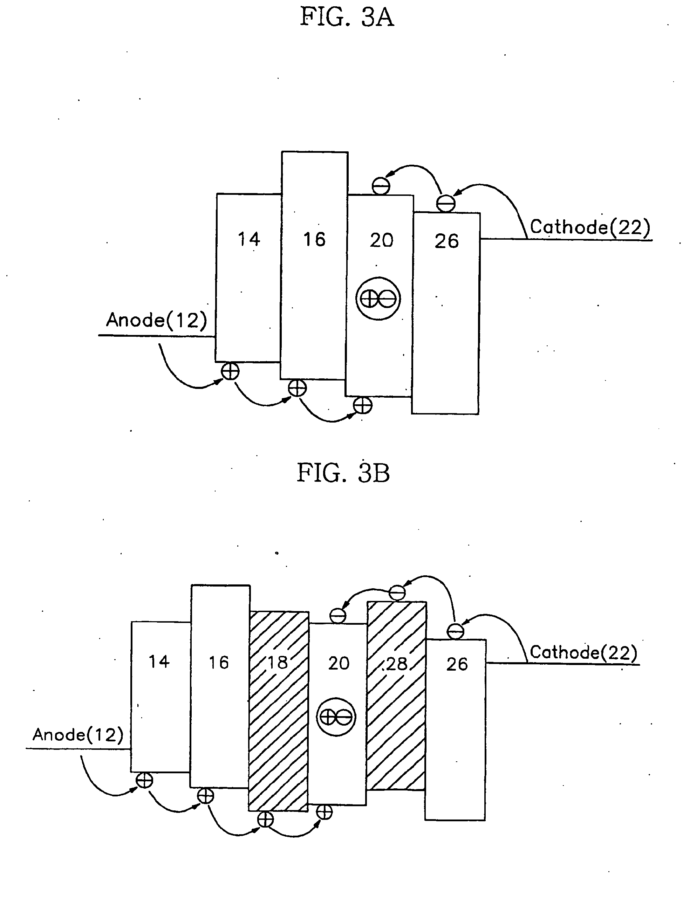

The energy band diagrams of OLEDs according to a conventional art and an embodiment of the present invention are shown in Figs. 3a and 3b, respectively. The reference numeral depicted in an energy band in Figs. 3a and 3b indicates that the energy band is the energy band of the layer in Fig. 2 to which same reference numeral are designated. As shown in Fig. 3A, the ionization potentials of the anode 12, the hole injecting layer 14, the hole transporting layer 16, and the light-emitting layer 20 of the conventional OLED gradually increases to naturally induce the hole into the light-emitting layer 20, and the electron affinities of the cathode 14, the electron injecting layer 24, the electron transporting layer 26, and the light-emitting layer 20 of the conventional OLED gradually increases to naturally induce the electron into the light-emitting layer 20.

In contrast, in the OLED according to an embodiment of the present invention shown in Fig. 3b, the electron blocking layer 28 having the electron affinity higher than that of the light-emitting layer 20 is formed between the electron transporting layer 26 and the light-emitting layer 20, to control the amount of the electrons injected to the light-emitting layer 20. In addition, the hole inducing layer 18 having the ionization potential higher than that of the light-emitting layer 20 is provided between the hole transporting layer 16 and the light-emitting layer 20, to increase the hole density of the light-emitting layer 20.

In the present invention, the anode 12 can be made of materials having a high work function, for example, Indium Tin Oxide(ITO), polyaniline and Ag, and the cathode 22 can be made of materials having a low work function, for example, Al, Mg-Ag, Li, and Ca. The organic light-emitting layer 20 can be made of various conventional organic compounds under the condition that the organic compounds satisfy the above-described energy relationship with the materials for producing the hole inducing layer 18 and/or the electron blocking layer 28. Examples of the organic compounds for producing the organic light-emitting layer 20 include tris(8-quinolinolate)aluminum (Alq₃), 10-benzo[h]quinolinol-beryllium complex (BeBq₂) or tris(4-methyl-8-quinolinolate)aluminum (Almq), which emits green light (550 nm). Examples of the blue (460nm) luminescent single compound include a metal complex such as Bis[2-(2-benzoxazolyl)phenolato]Zinc(II) (ZnPBO) or Bis(2-methyl-8-quinolinolato)(para-phenyl-phenolato)aluminum (Balq) or an organic compound such as strylarylene derivatives, 4,4'-bis(2,2'-biphenylvinyl)-1,1'-biphenyl (DPVBi), oxadiazole derivatives or bisstrylanthracene-based derivatives such as 4,4'-Bis((2-carbazole)vinylene)biphenyl (BczVBi). Examples of the red (590nm) luminescent organic compound include 4-(dicyanomethylene)-2-methyl-6-(p-dimethylaminostyryl)-4H-pyran (DCM) or DCM-based 4-dicyanomethylene-6-cp-julolidinostyryl-2-tert-butyl-4H-pyran (DCJTB). Besides these compounds, various other organic compounds or conjugated oligomers or polymers can be used to form the light-emitting layer 20. In addition, a host material having good electron/hole mobility and the luminescent efficiency and a dopant having various colors can be mixed to form the light-emitting layer 20, which generally called as a guest-host doping system.

Examples of materials to form the hole injecting layer 14 and the hole transporting layer includes porphyrinic compound such as copper phthalocyanine (CuPc, See United States Patent No. 4,356,429), tri(phenyldiamine) derivatives such as N,N'-diphenyl-N,N'bis(3-methylphenyl)-[1,1'-biphenyl]-4,4'-diamine (TPD), 4,4',4"-tris[3-methylphenyl(phenyl)amino]triphenylamine (m-MTDATA), N,N'-diphenyl-N,N'-bis(1-naphthylphenyl)-1,1'-biphenyl-4,4'-diamine (α -NPD), N,N,N'N'-tetrakis(m-methylphenyl)-1,3-diaminobenzene (PDA), 1,1-bis[N,N-di(p-tolyl)aminophenyl]cyclohexane (TPAC), strylamine derivatives and amine derivatives having fused aromatic ring such as N,N'-bis(1-naphthyl)-N,N'-diphenyl-benzidin. Examples of materials to form the electron injecting layer 24 and the electron transporting layer 26 include LiF, 1,2,4-triazole (TAZ), quinoline derivatives and Alq₃. The materials to form the hole inducing layer 18 or the electron blocking layer 28 can include the materials to form the hole injecting layer 14, the hole transporting layer 16, the electron injecting layer 24 and the electron transporting layer 26 under the condition that the materials for producing the hole inducing layer 18 and/or the electron blocking layer 28 satisfy the above-described energy relationship with the material for producing the light-emitting layer 20. The hole inducing layer 18 and/or the electron blocking layer 28 can be made of one or more materials, if necessary to satisfy the above-described energy relationship. Layers including the hole inducing layer 18 and the electron blocking layer 28 can be prepared by various conventional methods such as a spin-coating method, a thermal evaporation, a spin-casting method, a sputtering method, an electron-beam evaporation, and a chemical vapor deposition (CVD). Alternatively, two or more materials for producing the layers can be co-deposited by the above-mentioned methods. The anode 12 and the cathode 22 can be prepared by a conventional method such as a sputtering method, an ion plating method, a thermal or electron-beam evaporation, or a chemical vapor deposition. The thickness of the organic layers are not specifically restricted and can be determined according to the operation condition and the structure of the desired OLED. However, it is preferred that the thickness of each layer is within the range of from 5 nm to 500nm.

Hereinafter, the present invention will be explained in detail with reference to an example and a comparative example.

### [Example]

An Indium Tin oxide (ITO) coated glass substrate was ultrasonically washed and then washed with deionized water. The grease on the washed substrate was removed with gas phase toluene, and dried. To produce an OLED, a hole injection layer of thickness of 400Å was formed by vacuum depositing m-MTDATA on the ITO layer, and a hole transporting layer of thickness of 300Å was formed by vacuum depositing α -NPD on the hole injection layer. Then, the mixture of α -NPD and TAZ was vacuum deposited on the hole transporting layer to form a hole inducing layer of the thickness of about 200Å. The weight ratio of α -NPD:TAZ can be 1:0.5-1.5, and the ratio was 1:1 in this example. As the organic luminescent compound, Alq3 was vacuum deposited to a thickness of 600 Å to form the organic light-emitting layer. Then, TAZ(3-(4-Biphenyl)-4-phenyl-5-tert-butylphenyl)-1,2,4-triazole) was vacuum deposited to a thickness of 380Å to form an electron transporting layer on the organic light-emitting layer, and LiF of thickness of 7Å and Ag of thickness of 2000Å were subsequently deposited on the electron transporting layer to form an electron injection layer and a cathode.

### [Comparative Example]

Except for not depositing the mixture of α -NPD and TAZ for forming the hole inducing layer, an OLED was manufactured according to the method described in the above Example.

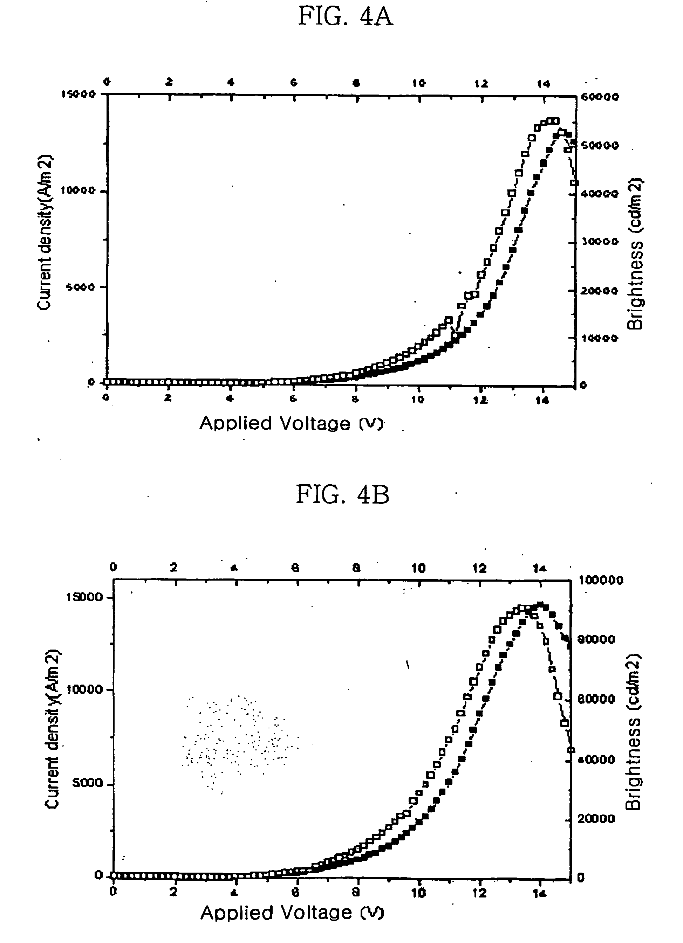

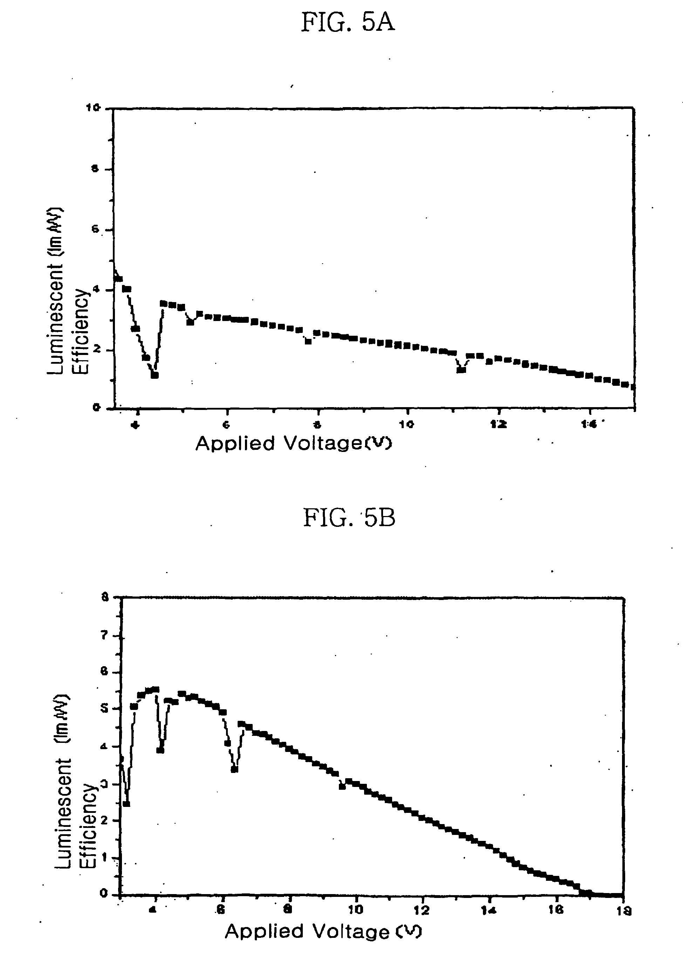

The relationship of an applied voltage vs. a current density and a brightness of the OLEDs according to the Comparative Example and the Example were measured, and shown in Figs. 4a and 4b, respectively. In Figs. 4A and 4B, the symbol "□" stands for the brightness and the symbol " ■" stands for the current density. As shown in Figs. 4a and 4b, the brightness of the OLED of the Example (Fig. 4B) is very high in comparison with that of the OLED of the Comparative Example(Fig. 4A). The relationship of an applied voltage vs. a luminescent efficiency of the OLEDs according to the Comparative Example and the Example were measured, and shown in Figs. 5a and 5b, respectively. The luminescent efficiency η was calculated by the equation η = π x L/[V x J], wherein L represents a brightness, V represents an applied voltage, and J represents a current density. As shown in Figs. 5a and 5b, the luminescent efficiency of the OLED of the Example (Fig. 5B) is very high in comparison with that of the OLED of the Comparative Example(Fig. 5A), especially at low applied voltage.

In the OLED of the present invention, the material having the ionization potential higher than that of the light-emitting layer 20 is incorporated between the anode 12 and the light-emitting layer 20, which induces the hole generation and increases the hole density in the light-emitting layer 20. Also, the material having the electron affinity higher than that of the light-emitting layer 20 is incorporated between the cathode 22 and the light-emitting layer 20, which controls or decreases the amount of the injected electrons, and minimizes the number of electrons extinguished in a layer other than the light-emitting layer 20. Therefore, the possibility for recombination of the electrons and the holes in the light-emitting layer 20 increases, and the luminescent efficiency and the life time of the OLED increases.

## Claims

1. An organic light-emitting device comprising:
a first electrode formed on a substrate:
at least one organic layer including an organic light-emitting layer formed on the first electrode;
a second electrode formed on the organic layer; and
a hole inducing layer including a material having an ionization potential higher than that of the organic light-emitting layer and formed between the first electrode and the organic light-emitting layer,
further comprising a hole transporting layer formed on the first electrode,
**characterised in that** the hole inducing layer is formed between the hole transporting layer and the organic light-emitting layer.

2. The organic light-emitting device according to claim 1, wherein the hole inducing layer is formed by being mixed with the hole transporting layer.

3. The organic light-emitting device according to claim 1, further comprising an electron transporting layer formed on the light-emitting layer.

4. The organic light-emitting device according to claim 1, further comprising a hole injecting layer on the first electrode, and an electron injecting layer under the second electrode.

5. The organic light-emitting device according to claim 1, wherein the first electrode is made of ITO, the second electrode is made of Ag, the hole inducing layer includes the mixture of alpha-NPD and TAZ and the organic light-emitting layer is made of Alq3.

6. The organic light-emitting device according to claim 5, further comprising a hole injecting layer formed on the first electrode and comprising m-MTDATA, a hole transporting layer formed on the hole injecting layer and comprising alpha-NPD, and wherein the hole inducing layer is formed on the hole transporting layer and made of the mixture of alpha-NPD and TAZ.

## Patentansprüche

1. Organische Lichtemissionsvorrichtung, umfassend:
eine erste Elektrode, gebildet auf einem Substrat;
mindestens eine organische Schicht, umfassend eine organische Lichtemissionsschicht, gebildet auf der ersten Elektrode;
eine zweite Elektrode, gebildet auf der organischen Schicht; und
eine Loch-induzierende Schicht, umfassend ein Material mit einem Ionisierungspotential, das höher als das der organischen Lichtemissionsschicht ist, und das zwischen der ersten Elektrode und der organischen Lichtemissionsschicht gebildet ist,
des Weiteren umfassend eine Loch-transportierende Schicht, gebildet auf der ersten Elektrode,
**dadurch gekennzeichnet, dass** die Loch-induzierende Schicht zwischen der Loch-transportierenden Schicht und der organischen Lichtemissionsschicht gebildet ist.

2. Organische Lichtemissionsvorrichtung gemäß Anspruch 1, wobei die Loch-induzierende Schicht **dadurch** gebildet ist, dass sie mit der Loch-transportierenden Schicht gemischt ist.

3. Organische Lichtemissionsvorrichtung gemäß Anspruch 1, des Weiteren umfassend eine Elektronen-transportierende Schicht, gebildet auf der Lichtemissionsschicht.

4. Organische Lichtemissionsvorrichtung gemäß Anspruch 1, des Weiteren umfassend eine Loch-injizierende Schicht auf der ersten Elektrode und eine Elektronen-injizierende Schicht unter der zweiten Elektrode.

5. Organische Lichtemissionsvorrichtung gemäß Anspruch 1, wobei die erste Elektrode aus ITO hergestellt ist, die zweite Elektrode aus Ag hergestellt ist, die Loch-induzierende Schicht eine Mischung aus alpha-NPD und TAZ enthält und die organische Lichtemissionsschicht aus Alq3 hergestellt ist.

6. Organische Lichtemissionsvorrichtung gemäß Anspruch 5, des Weiteren umfassend eine Loch-injizierende Schicht, gebildet auf der ersten Elektrode und umfassend m-MTDATA, eine Loch-transportierende Schicht, gebildet auf der Loch-injizierenden Schicht und umfassend alpha-NPD, und wobei die Loch-induzierende Schicht auf der Loch-transportierenden Schicht gebildet ist und aus der Mischung von alpha-NPD und TAZ hergestellt ist.

## Revendications

1. Dispositif électroluminescent organique comprenant :
une première électrode formée sur un substrat ;
au moins une couche organique comprenant une couche électroluminescente organique formée sur la première électrode ;
une deuxième électrode formée sur la couche organique ; et
une couche d'induction de trous comprenant un matériau ayant un potentiel d'ionisation supérieur à celui de la couche électroluminescente organique et formée entre la première électrode et la couche électroluminescente organique,
comprenant en outre une couche de transport de trous formée sur la première électrode,
**caractérisé en ce que** la couche d'induction de trous est formée entre la couche de transport de trous et la couche électroluminescente organique.

2. Dispositif électroluminescent organique selon la revendication 1, dans lequel la couche d'induction de trous est formée en étant mélangée avec la couche de transport de trous.

3. Dispositif électroluminescent organique selon la revendication 1, comprenant en outre une couche de transport d'électrons formée sur la couche électroluminescente.

4. Dispositif électroluminescent organique selon la revendication 1, comprenant en outre une couche d'injection de trous sur la première électrode, et une couche d'injection d'électrons sous la deuxième électrode.

5. Dispositif électroluminescent organique selon la revendication 1, dans lequel la première électrode est constituée d'ITO, la deuxième électrode est constituée d'Ag, la couche d'induction de trous comprend le mélange d'alpha-NPD et de TAZ et la couche électroluminescente organique est constituée d'Alq3.

6. Dispositif électroluminescent organique selon la revendication 5, comprenant en outre une couche d'injection de trous sur la première électrode et comprenant du m-MTDATA, une couche de transport de trous formée sur la couche d'injection de trous et comprenant de l'alpha-NPD, et dans lequel la couche d'induction de trous est formée sur la couche de transport de trous et constituée du mélange d'alpha-NPD et de TAZ.
